Europäisches Patentamt

European Patent Office

Office européen des brevets

(19)

(11) Veröffentlichungsnummer: **0 200 874**
**A1**

(12) **EUROPÄISCHE PATENTANMELDUNG**

(21) Anmeldenummer: **86102897.5**

(22) Anmeldetag: **05.03.86**

(51) Int. Cl.4: **H01L 21/306 , H01L 21/38**

(30) Priorität: **19.04.85 DE 3514301**

(43) Veröffentlichungstag der Anmeldung:
**17.12.86 Patentblatt 86/46**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **März, Reinhard, Dr.**
**Hofangerstrasse 79**
**D-8000 München 83(DE)**
Erfinder: **Heise, Gerhard, Dipl.-Phys.**
**Bert-Brecht-Allee 10**
**D-8000 München 83(DE)**

(54) **Verfahren zur Herstellung eines Oberflächengitters mit einer bestimmten Gitterkonstante auf einem tieferliegenden Oberflächenbereich einer Mesastruktur.**

(57) Verfahren zur Herstellung eines Oberflächengitters (1) mit einer bestimmten Gitterkonstanten (a) auf einem tieferliegenden Oberflächenbereich (10) einer auf der Oberfläche eines Substrats (3) aus einem Halbleitermaterial durch naßchemisches Ätzen mittels Maske erzeugten Mesastruktur (2). Es wird ein besonders einfaches und sehr billiges Verfahren dieser Art angegeben. Dazu wird die Mesastruktur (2) in eine feinstrukturierte, ein Oberflächengitter (4) mit der bestimmten Gitterkonstanten (a) aufweisende Oberfläche des Substrats (3) mittels eines anisotropen Ätzmittels geätzt, das bereits zur Herstellung des Oberflächengitters (4) verwendet wurde. Dabei wird dieses Oberflächengitter (4) in einem maskenfreien Bereich (20), der den tieferliegenden Oberflächenbereich (10) der Mesastruktur (2) definiert, unverändert in die Tiefe übertragen.

**FIG 2**

EP 0 200 874 A1

Verfahren zur Herstellung eines Oberflächengitters mit einer bestimmten Gitterkonstanten auf einem tieferliegenden Oberflächenbereich einer Mesastruktur

Die vorliegende Erfindung betrifft ein Verfahren zur Herstellung eines Oberflächengitters mit einer bestimmten Gitterkonstanten auf einem tieferliegenden Oberflächenbereich einer stufigen Struktur nach dem Oberbegriff des Patentanspruchs 1.

Für die Realisierung eines DFB-MCRW-Lasers in Einschrittepitaxie ist es notwendig, Gitter in einem tieferliegenden Bereich unmittelbar neben einem erhabenen Bereich einer Mesastruktur herzustellen. Ein DFB-MCRW-Laser und seine Herstellung in Einschrittepitaxie ist in der älteren Patentanmeldung P 34 37 209.1 mit dem Titel "Verbesserung zu einem Monomoden-Diodenlaser" vorgeschlagen.

Denkbar wäre es, das Oberflächengitter auf dem tieferliegenden Bereich durch ein Verfahren mit Mehrlagenmaskierung herzustellen. Dabei muß aber das Problem umgangen werden, daß Fotolack auf Substrate bzw. Wafer mit Mesastrukturen nicht aufgeschleudert werden kann.

Aufgabe der vorliegenden Erfindung ist es, ein besonders einfaches und sehr billiges Verfahren der eingangs genannten Art anzugeben.

Diese Aufgabe wird gemäß dem kennzeichnenden Teil des Patentanspruchs 1 dadurch gelöst, daß die stufige Struktur in eine fein strukturierte, ein Oberflächengitter mit der bestimmten Gitterkonstanten aufweisende Oberfläche des Substrats mittels eines anisotropen, in zumindest einer zur feinstrukturierten Oberfläche schrägen Richtung am langsamsten ätzenden Ätzmittels geätzt wird, wobei in einem den tieferliegenden Oberflächenbereich der stufigen Struktur definierenden maskenfreien Bereich das Relief des dem anisotropen Ätzmittel ausgesetzten Oberflächengitters der maskierten feinstrukturierten Oberfläche mehr oder weniger formgetreu aber unter Beibehaltung der bestimmten Gitterkonstanten in die Tiefe übertragen wird, wo es nach Beendigung des Ätzvorganges das gewünschte Oberflächengitter bildet.

Das erfindungsgemäße Verfahren ist selbstjustierend. Das Oberflächengitter der feinstrukturierten Oberfläche des Substrats muß nur der Bedingung genügen, daß seine Gitterkonstante mit der Gitterkonstanten des gewünschten Oberflächengitters auf dem tieferliegenden Oberflächenbereich übereinstimmt. Ansonsten kann das Profil der Rillen des Oberflächengitters der feinstrukturierten Oberfläche des Substrats weitgehend eine beliebige Form aufweisen. Dieses Gitter kann beispielsweise schwach wellig ausgebildet sein oder aber auch ein rechteckförmiges Rillenprofil aufweisen.

Vorteilhaft ist es aber, wenn gemäß dem Patentanspruch 2 das Oberflächengitter der feinstrukturierten Oberfläche des Substrats durch naßchemisches Ätzen mit zumindest im wesentlichen dem gleichen anisotropen Ätzmittel hergestellt wird, wie es beim Ätzen der stufigen Struktur verwendet wird. In diesem Fall hat das Oberflächengitter der feinstrukturierten Oberfläche des Substrats bereits von vorneherein das gleiche Rillenprofil, wie das gewünschte Oberflächengitter. Das Oberflächengitter der feinstrukturierten Oberfläche des Substrats wird in diesem Fall im wesentlichen unverändert in die Tiefe übertragen, wodurch eine sehr gute Reproduzierbarkeit des Gitters auf dem tieferliegenden Oberflächenbereich erhalten werden kann.

Bei dem erfindungsgemäßen Verfahren bleiben die von der Maske abgedeckten Bereiche der strukturierten Oberfläche als erhabene Bereiche stehen, die durch einen Stufenübergang von den tieferliegenden Bereichen getrennt sind. Der Begriff "stufige Struktur" ist allgemein so aufzufassen, daß die Struktur Stufen aufweist. Unter der Maske, die auf dem Relief der feinstrukturierten Oberfläche dicht aufliegt, so daß in die von ihr abgedeckten feinstrukturierten Oberflächenbereiche von der Seite her kein Ätzmittel eindringen kann, bleibt das Oberflächengitter der feinstrukturierten Oberfläche stehen, mit der das in die Tiefe abgesenkte Oberflächengitter die gleiche Phasenlage aufweist. Dieses stehengebliebene Oberflächengitter auf den erhabenen Bereichen der gestuften Struktur kann im Fall des MCRW-Lasers, wo dieser erhabene Bereich streifenförmig ausgebildet ist, zur Gainkopplung verwendet werden, da über den sich räumlich ändernden Übergangswiderstand eine Modulation des Injektionsstromes stattfindet.

Die Erfindung wird beispielhaft anhand der Figuren in der folgenden Beschreibung näher erläutert. Von den Figuren zeigen:

Figur 1 in perspektivischer Darstellung ein Substrat mit einer feinstrukturierten Oberfläche in Form eines Oberflächengitters mit im Profil dreieckförmigen Rillen, das zur Herstellung einer Mesastruktur mit einer streifenförmigen Ätzmaske abgedeckt ist, und

Figur 2 das Gebilde nach Figur 1 in der gleichen Darstellung nach dem Ätzen der stufigen Struktur.

Die durch die Figuren angedeutete relativ einfache stufige Struktur bezieht sich auf die Herstellung eines MCRW-Lasers, der im wesentlichen nur einen streifenförmigen erhabenen Bereich benötigt. Selbstverständlich kann das Verfahren auch für kompliziertere stufige Strukturen verwendet werden.

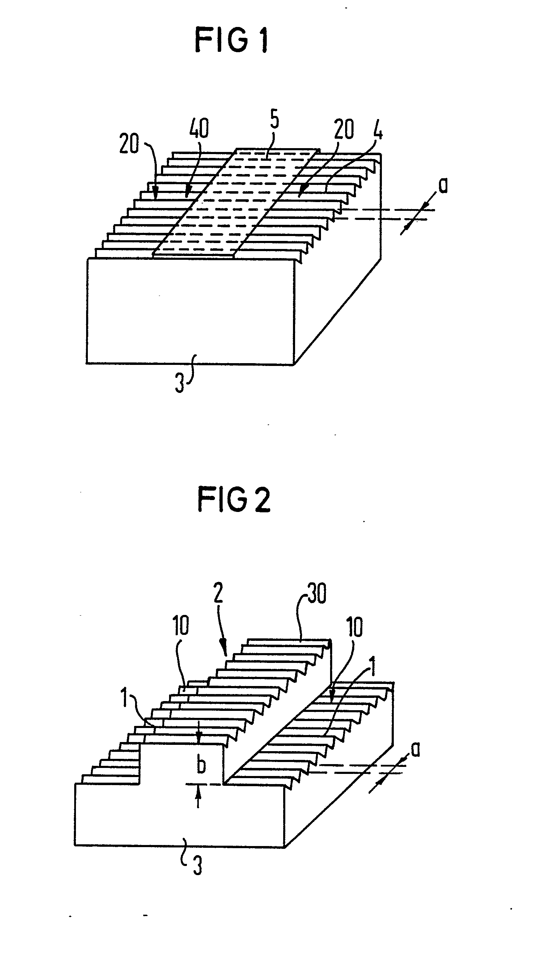

Zur Herstellung der feinstrukturierten Oberfläche 40 nach Figur 1 wird beispielsweise so vorgegangen, daß in die Oberfläche eines Wafers 3 mit den für die spätere Verwendung erforderlichen epitaktischen Schichtsystem, die in den Figuren nicht dargestellt sind, naßchemisch mit einem anisotropen Ätzmittel ein Oberflächengitter 4 mit im Profil V-förmigen Rillen geätzt wird, und zwar durch Freilegen der (111)-Flächen des Kristallmaterials des Substrats unter der Oberfläche 40. Dieses Oberflächengitter 4 erstreckt sich über die ganze Oberfläche 40 und weist die Gitterkonstante a auf. Als Maske wird Fotolack verwendet, der mittels eines Interferenzmusters belichtet wird.

Zur Herstellung der stufigen Struktur 2 nach Figur 2 mit dem streifenförmigen erhabenen Bereich 30 wird auf das Oberflächengitter 4 erneut Fotolack aufgetragen, so, daß er auf dem Relief dieses Gitters überall dicht aufliegt. Durch Maskenbelichtung wird ein Fotoresist-Streifen 5 erzeugt, dessen Längsrichtung quer, beispielsweise senkrecht, zu den Rillen des Oberflächengitters 4 verläuft, und unter dem der erhabene Bereich 30 entsteht. Die übrigen Bereiche 20 des Oberflächengitters 4, die an die Längsseiten des Fotoresist-Streifens 5 grenzen, werden ganz freigelegt, damit bei der Herstellung der stufigen Struktur 2 das Ätzmittel ungehindert auf diese Bereiche 20 einwirken kann. Dabei wird die Oberfläche 40 mit dem darauf befindlichen Fotoresist-Streifen 5 mit dem gleichen Ätzmittel wie bei der Herstellung des Oberflächengitters 4 geätzt. Dadurch wird dieses Gitter in den Bereichen 20 seitlich neben dem Fotoresist-Streifen 5 unverändert in die Tiefe übertragen. Es entstehen die tieferliegenden Oberflächenbereiche 10 mit den gewünschten Oberflächengittern 1, die an den dazwischenliegenden streifenförmigen erhabenen Bereich 30 grenzen, auf dem der Rest des Oberflächengitters 4 nach Figur 1 stehengeblieben ist. Das stehengebliebene Gitter und die Gitter 1 auf den tieferliegenden Bereichen 10 haben die gleiche Phasenlage und die gleiche Gitterkonstante a.

Bei der praktischen Realisierung einer solchen stufigen Struktur 2 wurde beispielsweise ein Substrat 3 aus einem III-V-Halbleiter mit einem Ätzmittel geätzt, das aus einer Mischung aus Schwefelsäure, Wasserstoffperoxid und Wasser bestand, beispielsweise aus ungefähr 3 Teilen aus einer 25 %igen Schwefelsäure, 8 Teilen 30 %igem Wasserstoffperoxid und aus 35 Teilen Wasser. Die Prozentangaben verstehen sich als Volumenprozente.

Zur Herstellung des Oberflächengitters 4 wurde die Oberfläche des Substrats etwa 1 Minute lang mit diesem Ätzmittel geätzt, und zur Herstellung der stufigen Struktur 2 wurde etwa 1 -5 Minuten lang geätzt, wobei die Versenktiefe b von 0,2 -1,4 μm beträgt. Die Gitterkonstante a lag im Submikronbereich etwa bei 0,3 μm. Günstig ist es , die Ätzvorgänge bei niedrigen Temperaturen, beispielsweise bei oder in der Nähe von 0°C vorzunehmen.

**Ansprüche**

1. Verfahren zur Herstellung eines Oberflächengitters (1) mit einer bestimmten Gitterkonstanten (a) auf einem tieferliegenden Oberflächenbereich (10) einer auf der Oberfläche eines Substrats (3) aus einem Kristallmaterial durch naßchemisches Ätzen mittels Maske erzeugten stufigen Struktur (2), insbesondere einer Mesastruktur, **dadurch gekennzeichnet**, daß die stufige Struktur (2) in eine feinstrukturierte, ein Oberflächengitter - (4) mit der bestimmten Gitterkonstanten (a) aufweisende Oberfläche (40) des Substrats (3)mittels eines anisotropen, in zumindest einer zur feinstrukturierten Oberfläche (40) schrägen Richtung am langsamsten ätzenden Ätzmittels geätzt wird, wobei in einem den tieferliegenden Oberflächenbereich (10) der stufigen Struktur (2) definierenden maskenfreien Bereich (20) das Relief des dem anisotropen Ätzmittel ausgesetzten Oberflächengitters (4) der maskierten, feinstrukturierten Oberfläche (40) mehr oder weniger formgetreu aber unter Beibehaltung der bestimmten Gitterkonstanten (a) in die Tiefe übertragen wird, wo es nach Beendigung des Ätzvorganges das gewünschte Oberflächengitter - (1) bildet.

2. Verfahren nach Anspruch 1, **dadurch gekennzeichnet**, daß das Oberflächengitter (4) der feinstrukturierten Oberfläche (40) des Substrats (3) durch naßchemisches Ätzen mit zumindest im wesentlichen dem gleichen anisotropen Ätzmittel hergestellt wird, wie es beim Ätzen der stufigen Struktur (2) verwendet wird.

# FIG 1

# FIG 2

**Europäisches Patentamt**

**EUROPÄISCHER RECHERCHENBERICHT**

Nummer der Anmeldung

EP 86 10 2897

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 135 510 (SEMICONDUCTOR ENERGY LABORATORY CO. LTD.) * Zusammenfassung; Figur 2 * | 1 | H 01 L 31/06 H 01 L 31/02 |
| D,A | JOURNAL OF APPLIED PHYSICS, Band 54, Nr. 11, November 1983, Seiten 6705-6707, American Institute of Physics, New York, US; P. SICHANUGRIST et al.: "Amorphous silicon solar cells with graded boron-doped active layers" * Insgesamt * | 1 | |
| A | US-A-4 409 424 (G. DEVAUD) * Zusammenfassung * | 1 | |
| A | US-A-4 217 148 (D. CARLSON) * Patentansprüche * | 1 | RECHERCHIERTE SACHGEBIETE (Int. Cl.4) H 01 L |
| A | US-A-4 396 793 (A. MADAN) * Patentansprüche * | | |
| A | EP-A-0 051 980 (ATLANTIC RICHFIELD CO.) * Zusammenfassung * | 4 | |

Der vorliegende Recherchenbericht wurde für alle Patentansprüche erstellt.

| Recherchenort | Abschlußdatum der Recherche | Prüfer |
|---|---|---|
| DEN HAAG | 29-08-1986 | GALLO G. |